# FASCICULE DE BREVET EUROPEEN

(11) **EP 1 370 707 B1**
(45) Date de publication et mention de la délivrance du brevet: **04.12.2019**
(21) Numéro de dépôt: 02713017.8
(22) Date de dépôt: 06.03.2002
(51) Int. Cl.: C23C 8/00, C23C 8/20, C23C 10/06, C23C 14/04, C23C 16/04, C23C 16/455, C23C 16/458, C04B 41/45

(54) **PROCEDE POUR LA DENSIFICATION PAR INFILTRATION CHIMIQUE EN PHASE VAPEUR DE SUBSTRATS POREUX AYANT UN PASSAGE CENTRAL**
VERFAHREN ZUR VERDICHTUNG PORÖSER SUBSTRATE, MIT EINEM ZENTRALEN DURCHGANG, MITTELS CHEMISCHER DAMPFINFILTRATION
CHEMICAL VAPOUR INFILTRATION METHOD FOR DENSIFYING POROUS SUBSTRATES HAVING A CENTRAL PASSAGE

(30) Priorité: 06.03.2001 FR 0103004
(43) Date de publication de la demande: 17.12.2003
(73) Titulaire: Safran Ceramics, 33185 Le Haillan (FR)
(72) Inventeur: GOUJARD, Stéphane, F-33700 Merignac (FR); BERNARD, Bruno, F-33600 Pessac (FR); RICHARD, Jean-Philippe, F-33320 Le Taillan Medoc (FR)
(74) Mandataire: Delumeau, François Guy
(86) Numéro de dépôt international: PCT/FR2002/000803
(87) Numéro de publication internationale: WO 2002/070775

(56) Documents cités:
- FR-A- 2 754 813
- US-A- 5 348 774
- US-A- 5 904 957
- US-A- 6 109 209

## Description

### Arrière-plan de l'invention

L'invention concerne la réalisation de pièces en matériau composite comprenant un substrat poreux densifié par une matrice, et plus particulièrement la réalisation de pièces munies d'un passage central.

L'invention est applicable notamment, mais non exclusivement, à la réalisation de disques de frein annulaires ou de divergents ou de cols de tuyères de moteurs fusées en matériau composite thermostructural.

Les matériaux composites thermostructuraux sont remarquables par leurs propriétés mécaniques élevées et leur capacité à conserver ces propriétés à haute température. Des exemples typiques de matériaux composites thermostructuraux sont les composites carbone-carbone (C-C) comprenant un substrat poreux de renfort en fibres de carbone densifié par une matrice en carbone et les composites à matrice céramique (CMC) comprenant un substrat poreux de renfort en fibres réfractaires (par exemple en carbone ou céramique) densifié par une matrice céramique (par exemple en carbure de silicium).

Les procédés de densification par infiltration chimique en phase vapeur sont bien connus. Un ou plusieurs substrats poreux sont placés à l'intérieur d'une enceinte. Une phase gazeuse contenant un ou plusieurs précurseurs du matériau constitutif de la matrice est introduite dans l'enceinte. Les conditions de température et de pression sont réglées pour permettre à la phase gazeuse de diffuser au sein de la porosité des substrats afin d'y déposer le matériau constitutif de la matrice par décomposition d'un constituant de la phase gazeuse ou par réaction entre plusieurs constituants. Différents précurseurs gazeux permettant d'obtenir des matrices carbone ou céramique sont bien connus.

Différents procédés connus seront maintenant brièvement décrits dans le cadre de la réalisation de disques de freins annulaires en matériau composite C-C étant noté que ces procédés sont applicables à la réalisation d'autres pièces annulaires ou munies d'un passage central, en matériau composite C-C ou autre matériau composite.

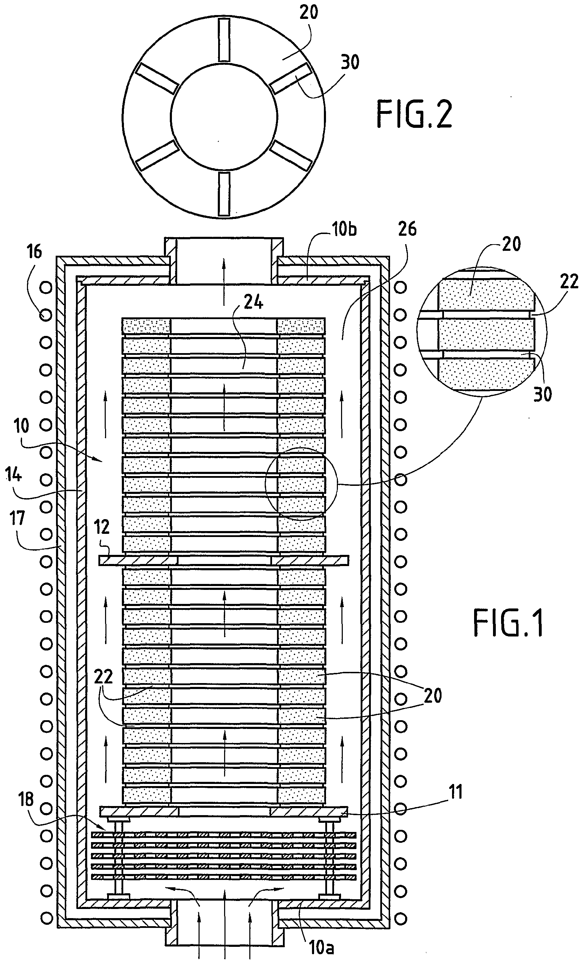

La figure 1 montre très schématiquement une enceinte 10 contenant un chargement de préformes annulaires ou substrats 20 en fibres de carbone. Le chargement est sous forme d'une pile de substrats ayant leurs passages centraux alignés verticalement. La pile peut être formée de plusieurs sections superposées séparées par un ou plusieurs plateaux de support intermédiaires 12.

Les substrats empilés sont séparés les uns des autres au moyen de cales d'espacement 30. Comme le montre la figure 2, les cales 30, dont le nombre peut varier, peuvent être disposées radialement. Elles ménagent entre substrats adjacents des intervalles 22 de hauteur sensiblement constante dans tout l'empilement tout en faisant communiquer le volume interne 24 de la pile, formé par les passages centraux alignés des substrats, avec le volume externe 26 situé à l'extérieur de la pile, dans l'enceinte 10.

Dans l'exemple de la figure 1, l'enceinte contient une seule pile de substrats. En variante, plusieurs piles de substrats pourront être disposées côte à côte dans la même enceinte.

L'enceinte 10 est chauffée au moyen d'un induit 14, par exemple en graphite qui définit l'enceinte 10 et qui est couplé inductivement avec un inducteur 16 situé à l'extérieur d'une enveloppe 17 entourant l'induit. D'autres modes de chauffage peuvent être utilisés, par exemple chauffage résistif (effet Joule).

Une phase gazeuse contenant un ou plusieurs précurseurs de carbone, typiquement des hydrocarbures tels que méthane et/ou propane, est admise dans l'enceinte 10. Dans l'exemple illustré, l'admission est réalisée à travers le fond 10a de l'enceinte. La phase gazeuse traverse une zone de préchauffage 18 formée de plusieurs plateaux percés disposés les uns au-dessus des autres dans la partie inférieure de l'enceinte, au-dessous d'un plateau 11 de support de la pile de substrats. La phase gazeuse réchauffée par les plateaux de préchauffage qui sont portés à la température régnant dans l'enceinte s'écoule librement dans l'enceinte en passant à la fois dans le volume interne 24 et le volume externe 26 et dans les intervalles 22.

La phase gazeuse résiduelle est extraite de l'enceinte par aspiration à travers une sortie ménagée dans le couvercle 10b.

L'inconvénient d'une telle disposition est qu'une relativement faible proportion de la phase gazeuse circule dans les intervalles 22, de sorte que les substrats 20 sont faiblement alimentés en phase gazeuse réactive, puisque leurs plus grandes faces sont adjacentes aux intervalles 22.

Afin d'éviter cet inconvénient, il a été proposé dans le brevet US 5 904 957 de modifier la disposition des figures 1 et 2 de la façon schématiquement illustrée par les figures 3 et 4.

La phase gazeuse admise dans l'enceinte et issue de la zone de préchauffage 18 est canalisée par une paroi 19 vers le volume interne 24 de la pile de substrats 20 et le volume interne 24 est obturé par une paroi 25 à son extrémité opposée à celle où est admise la phase gazeuse. La sortie de phase gazeuse résiduelle hors de l'enceinte 10 communique avec le volume externe 26.

De la sorte, le flux de phase gazeuse est dirigé de manière à s'écouler du volume interne 24 vers le volume externe 26 en passant à travers la porosité des substrats 20 et à travers les intervalles 22, entre les cales d'espacement radiales 30.

Avec ce procédé d'infiltration chimique en phase vapeur du type à flux dirigé, l'alimentation des substrats 20 en phase gazeuse réactive est améliorée. Les intervalles 22 entre substrats ménagent des passages tels pour la phase gazeuse que les pressions dans les volumes interne 24 et externe 26 sont égales.

Un résultat similaire pourra être obtenu en réalisant une circulation inverse de la phase gazeuse, c'est-à-dire du volume externe 26 vers le volume interne 24, le volume externe 26 étant obturé à son extrémité opposée à celle où est admise la phase gazeuse et le volume interne 24 communiquant avec la sortie de phase gazeuse résiduelle hors de l'enceinte.

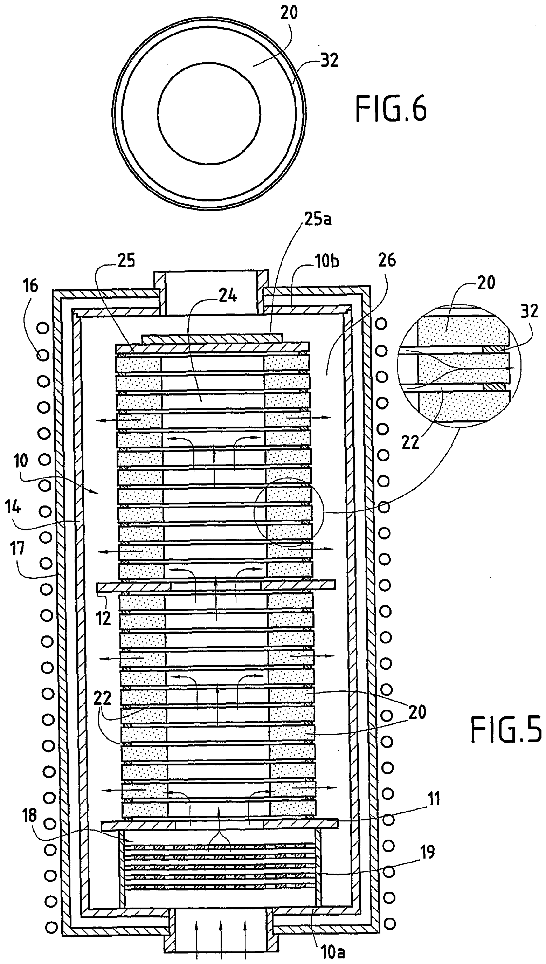

Une autre disposition telle qu'illustrée par les figures 5 et 6 a été proposée dans le document EP 0 792 385.

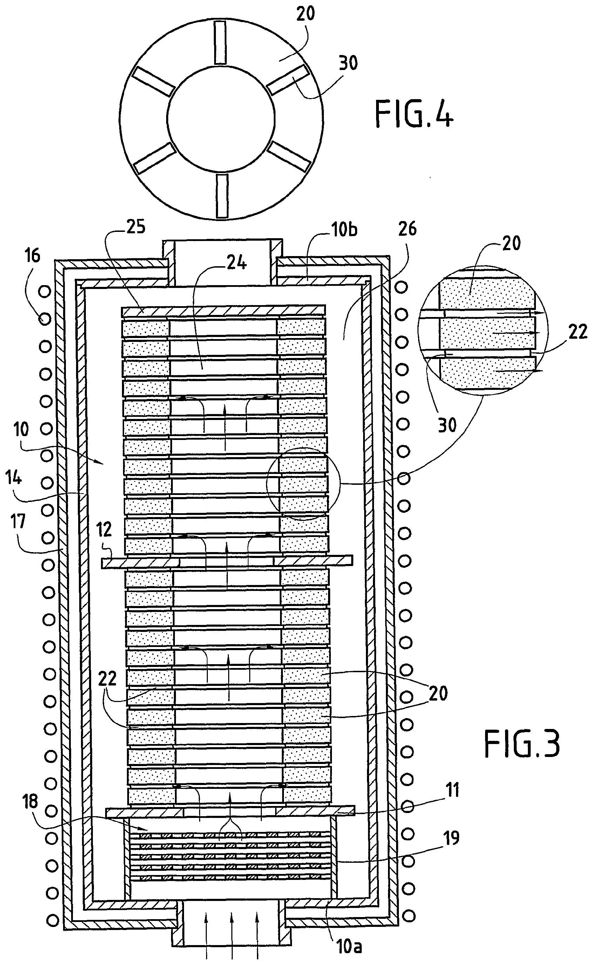

Cette disposition se distingue de celle des figures 3 et 4 en ce que les intervalles 22 entre substrats sont obturés en utilisant des cales d'espacement 32 annulaires disposées du côté du diamètre intérieur ou, comme illustré, du côté du diamètre extérieur des substrats 20.

On réalise ainsi un écoulement forcé de la phase gazeuse entre le volume interne 24 et le volume externe 26 à travers la porosité des substrats 20 et une différence de pression est établie entre ces deux volumes. Le mode de densification par infiltration chimique en phase vapeur mis en oeuvre est alors du type à gradient de pression.

Par rapport au mode d'infiltration isobare tel que mis en oeuvre avec la disposition des figures 1 et 2, le mode à gradient de pression avec flux forcé de phase gazeuse permet d'augmenter la cinétique de densification.

Toutefois, le processus est délicat à mettre en oeuvre. Comme spécifié dans le document EP-0 792 385, le chargement des substrats 20 dans l'enceinte 10 doit être réalisé avec minutie pour éviter des fuites de gaz à la base de la pile, en sortie de la zone de préchauffage, entre substrats adjacents, et au sommet de la pile. La paroi 25 peut être notamment surmontée d'un poids 25a lui permettant d'être maintenue appliquée de façon étanche sur le sommet de la pile en dépit de la surpression régnant dans celle-ci.

En outre, lorsque le processus est prolongé au-delà d'un seuil de densification des substrats, ce qui se traduit par une pression trop importante au centre de la pile, une modification de la microstructure du matériau de la matrice a été observée par la demanderesse, voire même la formation de quantités importantes de suies. Ces phénomènes sont indésirables car ils induisent un changement de propriété du matériau qui peut être pénalisant lors de son utilisation. Par ailleurs, ils peuvent imposer un arrêt du processus de densification avant que soit atteint le niveau de densité souhaité. Il est alors nécessaire de compléter ensuite la densification par exemple par une étape finale d'infiltration chimique en phase gazeuse en mode isobare, comme indiqué dans le document EP-0 792 384. De plus, l'augmentation de pression à l'intérieur de la pile au fur et à mesure de la densification produit un gonflage de la pile qui pourrait avoir des effets destructeurs.

Le document US5904957 décrit aussi un procédé de densification par infiltration chimique similaire à la demande, dans lequel la pression est maintenue à une valeur désirée, ne dépassant pas un seuil maximum admissible implicitement défini, afin de ne pas influencer la microstructure , et la section des passages de fuite est ajustée afin de ne pas avoir de stagnation du gaz (donc pas de risque sur la microstructure) mais bien un flux constant donc une différence de pression existante dès le début du process.

### Objet et résumé de l'invention

L'invention a pour but de fournir un procédé de densification par infiltration chimique en phase vapeur de substrats poreux présentant un passage central qui permet à la fois d'assurer une bonne alimentation des substrats en phase gazeuse réactive et d'obtenir un degré élevé de densification, plus rapidement que dans les configurations décrites dans le brevet US 5 904 957 précité, sans risque de modification de microstructure du matériau de la matrice densifiant les substrats et sans formation de dépôts indésirables.

Ce but est atteint grâce à un procédé selon la revendication 1.

Le procédé conforme à l'invention est remarquable en ce qu'il permet de combiner les avantages des procédés d'infiltration chimique en phase vapeur à flux dirigé et à flux forcé évoques plus haut, tout en ne présentant pas leurs inconvénients.

La différence de pression entre les volumes interne et externe est plafonnée, ce qui permet de ne pas dépasser le seuil de pression à partir duquel des modifications de microstructure du matériau constitutif de la matrice ou des dépôts parasites sont susceptibles de se produire ou à partir duquel le gonflage de la pile pourrait devenir préoccupant. Le processus d'infiltration peut alors être poursuivi sans inconvénient jusqu'à atteindre un niveau de densification relativement élevé, qui peut même éventuellement correspondre à la densité finale souhaitée pour les substrats densifiés, de sorte qu'une étape d'infiltration supplémentaire ne serait alors plus requise.

Il est nécessaire de se trouver en mode d'infiltration à gradient de pression dès le début du processus. Par conséquent, on confère à la section totale du ou des passages de fuite une valeur telle que la différence de pression entre le premier et le deuxième volume au début du processus de densification soit au moins égale à 15 % de la valeur de différence de pression obtenue en l'absence de passage(s) de fuite.

Il est en outre nécessaire que le seuil maximum de pression ne soit pas dépassé en fin du processus de densification. On confère alors à la section totale du ou des passages de fuite une valeur telle que la différence de pression entre le premier et le deuxième volume au début du processus de densification soit au plus égale à 85 % de la valeur de différence de pression obtenue en l'absence de passage(s) de fuite.

Le procédé peut être mis en oeuvre en formant à l'intérieur de l'enceinte au moins une pile de substrats avec leurs passages centraux alignés et en ménageant des espaces entre substrats adjacents au moyen de cales d'espacement, lesdits volumes interne et externe étant constitués par respectivement l'intérieur et l'extérieur de la ou des piles, et en aménageant au moins une des cales d'espacement pour former un ou plusieurs passages de fuite.

On peut utiliser au moins une cale annulaire munie d'au moins un passage radial formant passage de fuite.

En variante, on peut utiliser au moins une cale en plusieurs parties, par exemple des secteurs incurvés, ménageant entre elles des passages de fuite.

Dans le cas où des passages de fuite sont ménagés au niveau de plusieurs cales d'espacement, on pourra conférer aux sections des passages de fuite entre substrats adjacents une valeur variable sur la hauteur de la ou chaque pile. De préférence alors, la section de fuite entre substrats varie en sens croissant entre l'extrémité du premier volume où est admise la phase gazeuse et l'extrémité opposée.

Il est envisageable d'aménager chaque cale d'espacement pour former un ou plusieurs passages de fuite. Toutefois, le maintien de la section totale de fuite dans la limite voulue impose une section de passage réduite pour chaque passage de fuite, dans le cas d'un empilement d'un assez grand nombre de substrats. Au fur et à mesure de la densification, une obturation partielle des passages de fuite risque alors de se produire. En outre, l'aménagement de passages de fuite peut conduire à une fragilisation des cales d'espacement. Cette fragilisation peut être combattue en augmentant l'épaisseur des cales, mais cela pénalise alors la capacité de chargement en substrats à densifier.

Par conséquent, pour éviter ces inconvénients, il est alors préférable de former un ou plusieurs passages de fuite dans un nombre limité de cales d'espacement, voire dans une seule d'entre elles.

Il est possible aussi d'aménager un ou plusieurs passages de fuite ailleurs qu'au niveau d'une ou plusieurs cales d'espacement.

Ainsi, selon un autre mode de réalisation, on aménage au moins un passage de fuite sur le trajet de canalisation de la phase gazeuse entre l'entrée de la phase gazeuse dans l'enceinte et l'entrée dans ledit premier volume. Dans ce cas, le passage de fuite peut être aménagé au niveau d'une zone de préchauffage de la phase gazeuse.

Selon encore un autre mode de réalisation, on aménage au moins un passage de fuite à travers une paroi de fermeture dudit premier volume à son extrémité opposée à celle où est admise la phase gazeuse.

Dans ces autres modes de réalisation, on peut utiliser des cales d'espacement dont aucune ne ménage de passages de fuite entre substrats.

Le procédé selon l'invention peut être mis en œuvre en mode isotherme, c'est-à-dire avec chauffage sensiblement uniforme du ou des substrats, ou en mode à gradient de température, c'est-à-dire avec une partie du ou de chaque substrat portée à une température plus élevée qu'une autre partie. Le chauffage du ou des substrats avec gradient de température peut être réalisé par couplage direct entre le substrat et un inducteur.

### Brève description des dessins

L'invention sera mieux comprise à la lecture de la description faite ci-après à titre indicatif mais non limitatif en référence aux dessins annexés, sur lesquels :
- la figure 1 est une vue très schématique en coupe d'un chargement de substrats pour la mise en oeuvre du procédé connu d'infiltration chimique en phase vapeur à flux libre ;
- la figure 2 est une vue schématique en coupe de la pile de substrats de la figure 1 ;
- la figure 3 est une vue très schématique en coupe d'un chargement de substrats pour la mise en oeuvre du procédé connu d'infiltration chimique en phase vapeur à flux dirigé ;
- la figure 4 est une vue schématique en coupe de la pile de substrats de la figure 3 ;
- la figure 5 est une vue très schématique en coupe d'un chargement de substrats pour la mise en oeuvre du procédé connu d'infiltration chimique en phase vapeur à flux forcé ;
- la figure 6 est une vue schématique en coupe de la pile de substrats de la figure 5 ;

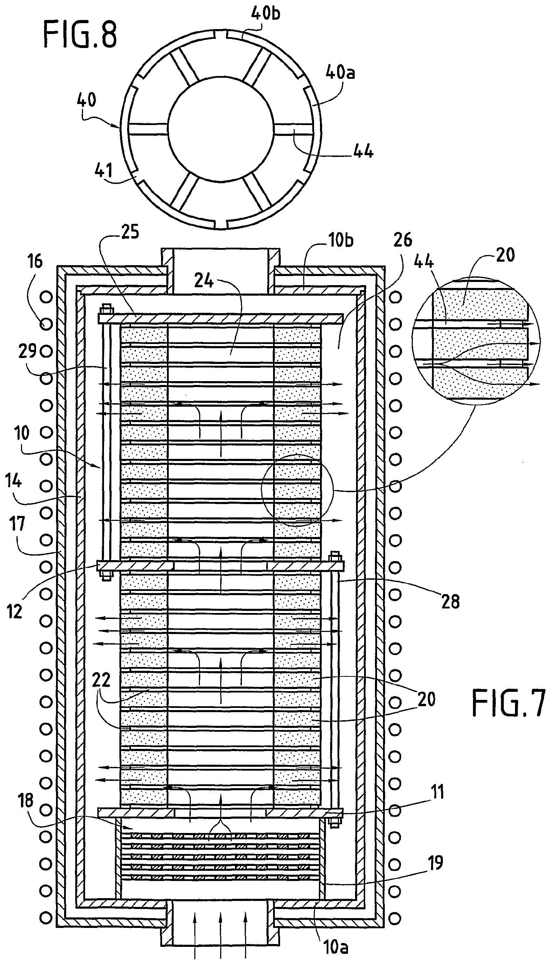

- la figure 7 est une vue très schématique en coupe d'une installation de densification montrant un mode particulier de réalisation d'un chargement de substrats en pile pour la mise en oeuvre d'un procédé selon l'invention, dans le cas de la densification simultanée d'une pluralité de substrats annulaires pour disques de frein en matériau composite ;
- la figure 8 est une vue schématique en coupe de la pile de substrats de la figure 7 ;

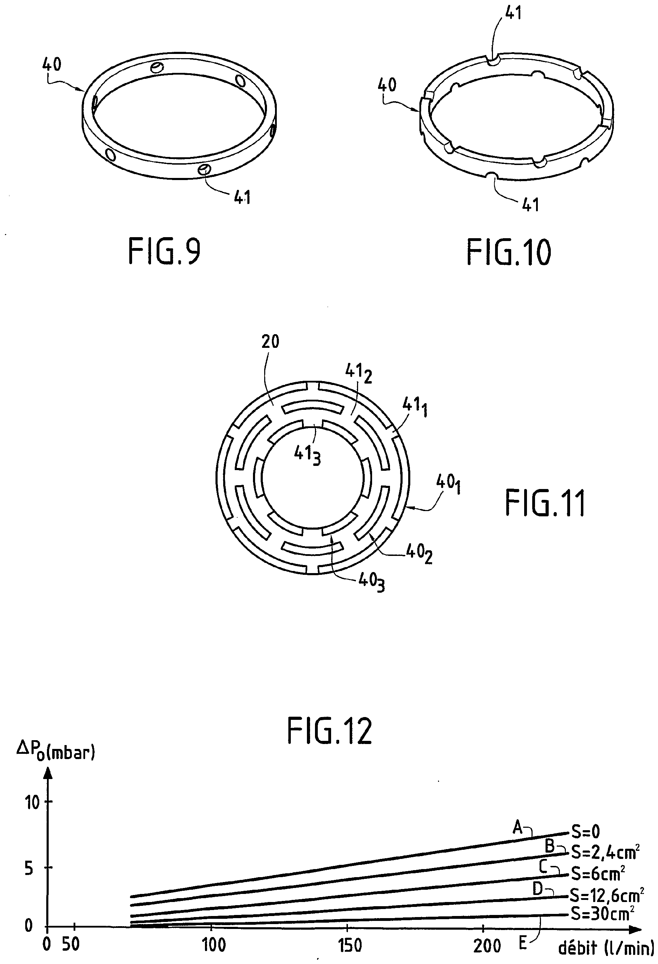

- les figures 9 et 10 sont des vues de détail à échelle agrandie de deux modes de réalisation d'une cale d'espacement convenant pour le chargement de substrats des figures 7 et 8 ;
- la figure 11 est une vue de détail d'un autre mode de réalisation de cales d'espacement convenant pour le chargement de substrats des figures 7 et 8 ;
- la figure 12 montre des courbes illustrant la variation de la différence de pression entre l'intérieur et l'extérieur d'une pile de substrats en fonction du débit d'un gaz admis dans le volume interne de la pile et de la section de fuite ;

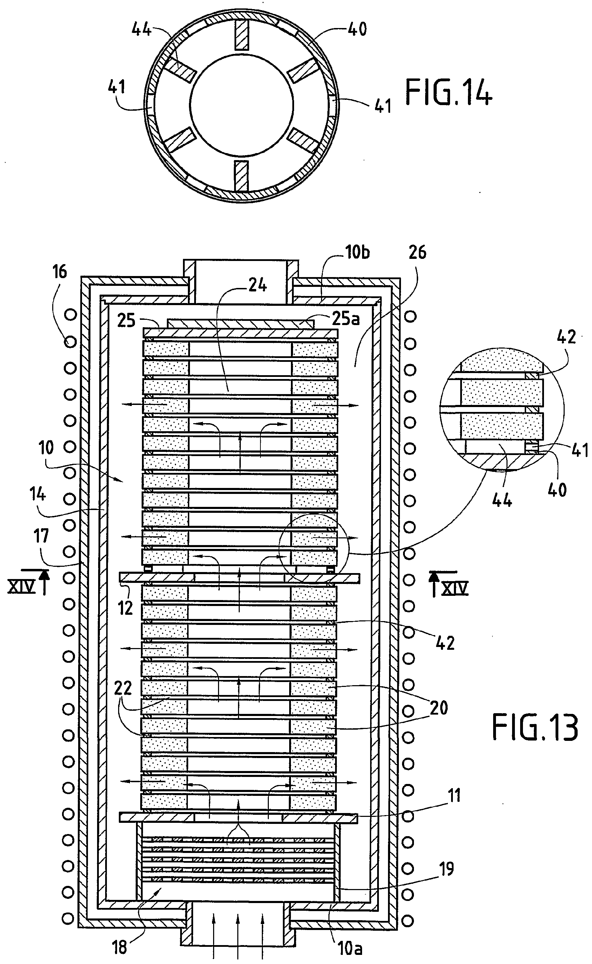

- la figure 13 est une vue très schématique en coupe montrant une variante de réalisation d'un chargement de substrats en pile pour la mise en oeuvre d'un procédé selon l'invention ;
- la figure 14 est une vue schématique en coupe selon le plan XIV-XIV de la figure 13 ;

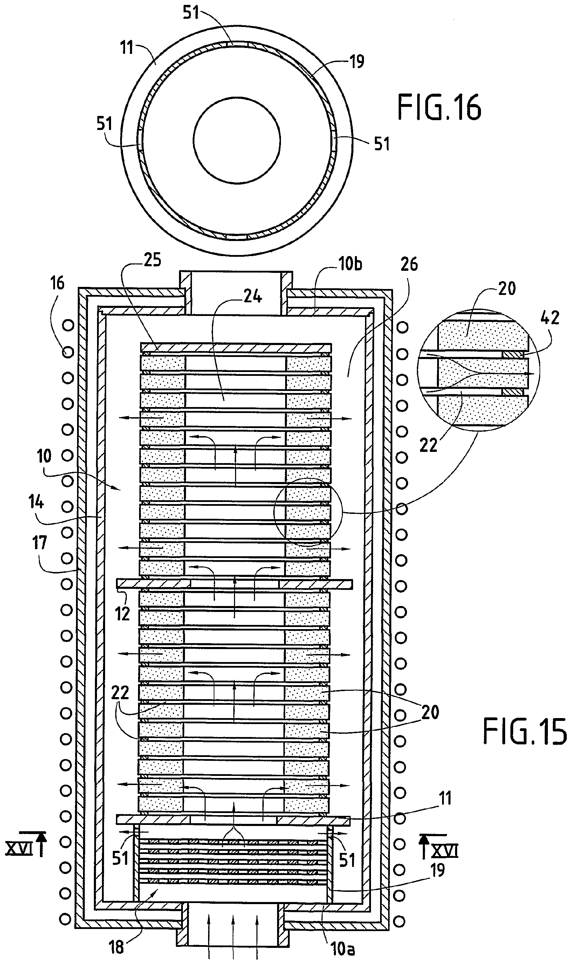

- la figure 15 est une vue très schématique en coupe d'une installation de densification pour la mise en oeuvre d'un autre mode de réalisation d'un procédé selon l'invention ;
- la figure 16 est une vue schématique partielle en coupe selon le plan XVI-XVI de la figure 15 ;

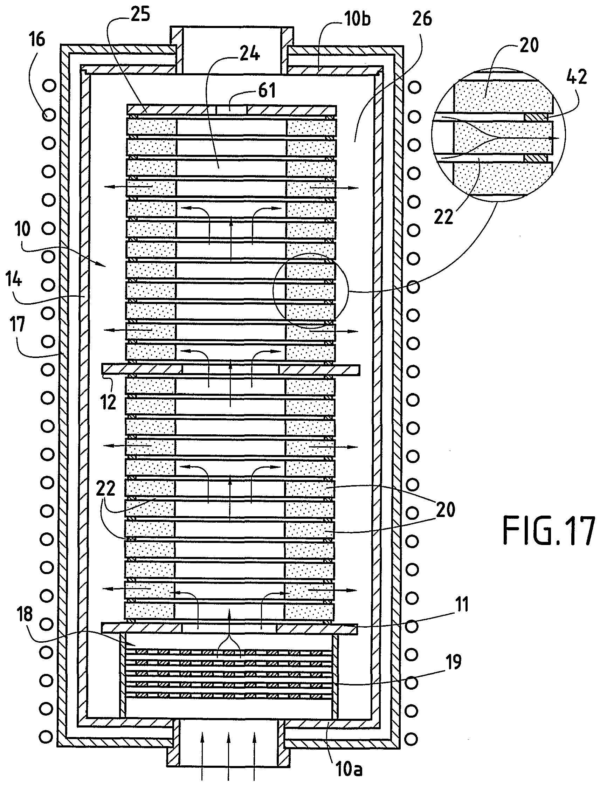

- la figure 17 est une vue schématique en coupe d'une installation de densification pour la mise en oeuvre d'encore un autre mode de réalisation d'un procédé selon l'invention ;

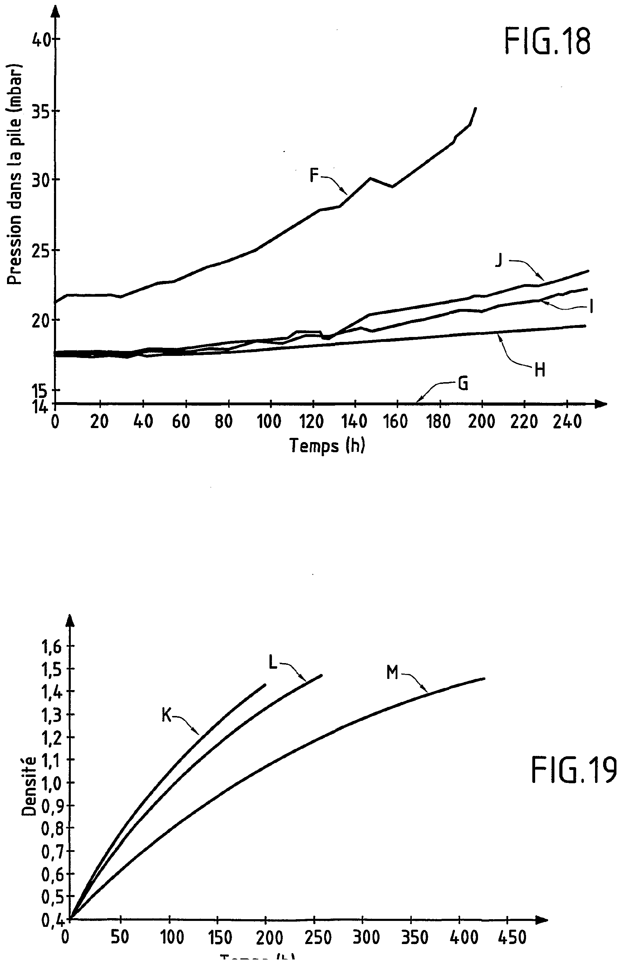

- la figure 18 montre des courbes illustrant la variation en fonction du temps de la pression de phase gazeuse réactive à l'intérieur d'une pile de substrats dans le cas des procédés de densification de l'art antérieur à flux forcé de phase gazeuse et à flux dirigé de phase gazeuse, et de procédés de densification selon l'invention ;
- la figure 19 montre des courbes illustrant la cinétique de densification des substrats dans le cas des procédés de densification de l'art antérieur à flux forcé de phase gazeuse et à flux dirigé de phase gazeuse, et d'un procédé de densification selon l'invention ;

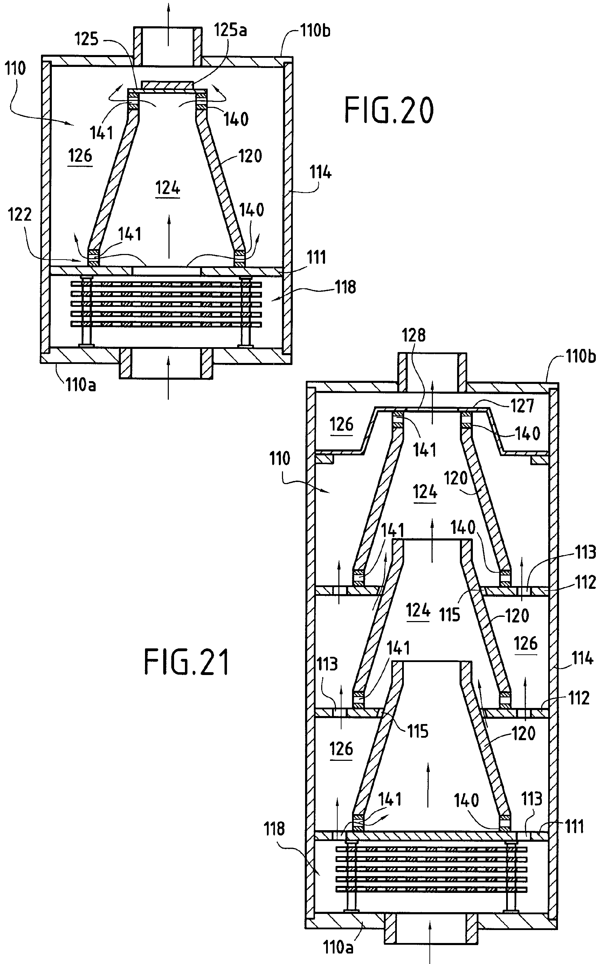

- la figure 20 est une vue très schématique en coupe d'une installation de densification d'un substrat pour la mise en oeuvre d'un procédé selon l'invention, dans le cas de la densification d'un substrat pour divergent de tuyère de moteur fusée ;
- la figure 21 est une vue très schématique en coupe d'une installation de densification de substrats en pile pour la mise en oeuvre d'un procédé selon l'invention dans le cas de la densification simultanée de plusieurs substrats pour divergents de tuyères de moteurs fusées ;

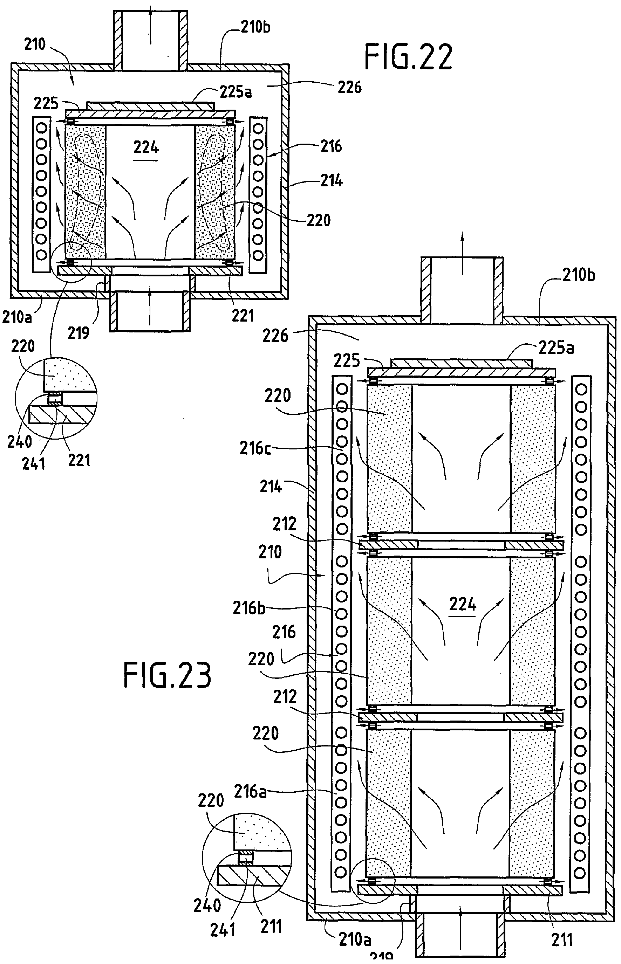

- la figure 22 est une vue très schématique en coupe d'une installation de densification d'un substrat pour la mise en oeuvre d'un procédé selon l'invention, dans le cas de la densification d'un substrat pour col de tuyère de moteur fusée ; et
- la figure 23 est une vue très schématique en coupe d'une installation de densification de substrats en pile pour la mise en œuvre d'un procédé selon l'invention dans le cas de la densification simultanée de plusieurs substrats pour cols de tuyères de moteurs fusées.

### Description détaillée de modes de réalisation

On se réfère directement aux figures 7 et 8, les figures 1 à 6 ayant été décrites précédemment. Les éléments communs aux modes de réalisation des figures 1 à 8 portent les mêmes références.

La figure 7 montre très schématiquement une enceinte 10 contenant un chargement de substrats annulaires 20 tels que des préformes annulaires pour disques de frein en matériau composite thermostructural. Les substrats 20 sont disposés pour former une pile verticale délimitant un volume interne 24 formé par les passages centraux alignés des substrats. La pile de substrats 20 repose sur un plateau support inférieur 11 et peut être formée de plusieurs sections superposées séparées par un ou plusieurs plateaux de support intermédiaires 12.

Bien qu'une seule pile de substrats soit représentée sur la figure 7, plusieurs piles pourront être disposées côte à côte dans l'enceinte.

L'enceinte est chauffée au moyen d'un induit 14 qui définit la paroi latérale de l'enceinte et est couplé inductivement avec un inducteur 16 extérieur à une enveloppe 17 entourant l'induit à l'extérieur de l'enceinte. En variante, le chauffage des substrats pourra être réalisé par couplage direct entre un inducteur et les substrats, lorsque la nature de ceux-ci le permet. Un procédé de densification de substrats poreux par infiltration chimique en phase vapeur avec chauffage des substrats par couplage inductif direct est décrit dans le document EP 0 946 461. Toujours en variante, le chauffage de la paroi 14 pourra être de type résistif.

Une phase gazeuse contenant un ou plusieurs précurseurs gazeux du matériau à déposer au sein de la porosité des substrats afin de les densifier est introduite dans l'enceinte 10 à travers le fond 10a de celle-ci. La phase gazeuse traverse une zone de préchauffage 18 située à la partie inférieure de l'enceinte et formée par exemple de plusieurs plateaux perforés superposés. Au niveau de la zone de préchauffage, la phase gazeuse est canalisée par une paroi 19 vers le volume interne 24, celui-ci étant obturé à son extrémité supérieure par une paroi 25 formant un couvercle qui repose sur la pile de substrats.

Chaque substrat 20 est séparé d'un substrat adjacent et, le cas échéant, d'un plateau support 11 ou 12 ou du couvercle 25 par une ou plusieurs cales d'espacement qui définissent des intervalles 22. Les cales d'espacement, ou au moins une partie d'entre elles, sont aménagées pour former des passages de fuite faisant communiquer le volume interne 24 de la pile avec le volume externe 26 situé à l'extérieur de la pile, dans l'enceinte, tout en permettant l'existence d'un gradient de pression entre les volumes 24 et 26.

Comme cela sera précisé plus loin, on confère à la valeur globale S des sections des passages de fuite définis par les cales d'espacement une valeur prédéterminée souhaitée. Il est alors souhaitable d'éviter l'existence de fuites parasites pouvant fausser la valeur de la section globale de fuite. A cet effet, on réalise un bridage de la pile de substrats 20 au moyen de colonnes ou chandelles 28 (une seule est visible sur la figure 7) qui relient le plateau support de base 11 au plateau support intermédiaire 12 avec leurs extrémités traversant les plateaux 11 et 12 fixées par boulonnage, et de colonnes ou chandelles 29 (une seule est visible sur la figure 7) qui relient de la même façon le plateau 12 et le couvercle 25 et assurent le maintien de celui-ci à l'encontre de la surpression régnant dans la pile.

La phase gazeuse admise dans l'enceinte circule du volume interne 24 vers le volume externe 26 en diffusant à travers les substrats poreux 20 et en passant à travers les passages de fuite, en dehors des substrats 20.

La phase gazeuse résiduelle est extraite de l'enceinte 10 à travers un passage formé dans la paroi supérieure 10b de l'enceinte, passage en relation avec des moyens d'aspiration tels qu'une pompe à vide (non représentée).

Selon une variante de réalisation, la phase gazeuse issue de la zone de préchauffage peut être canalisée vers le volume externe 26 qui est alors obturé à sa partie supérieure. La phase gazeuse circule alors de l'extérieur vers l'intérieur de la pile en traversant les substrats 20 et les passages de fuite formés dans des intervalles 22, et la phase gazeuse résiduelle est extraite à partir du volume interne 24 alors ouvert à sa partie supérieure.

Selon encore une variante, l'admission de la phase gazeuse peut être effectuée à travers le couvercle de l'enceinte, la zone de préchauffage étant alors située à la partie supérieure de l'enceinte. Celui des volumes interne 24 et externe 26 dans lequel la phase gazeuse est canalisée est alors obturé à sa partie inférieure tandis que l'autre volume est ouvert à sa partie inférieure pour permettre l'extraction de la phase gazeuse résiduelle à travers un passage formé dans le fond de l'enceinte.

On notera aussi que le procédé peut être mis en oeuvre avec un seul substrat annulaire. La circulation de la phase gazeuse s'effectue de l'intérieur vers l'extérieur du substrat, ou inversement, à travers le substrat et à travers un ou plusieurs passages de fuite extérieurs au substrat. Le ou les passages de fuite peuvent être formés dans des cales d'espacement ménageant un intervalle entre les faces opposées du substrat et des parois voisines.

Dans le mode de réalisation de la figure 8, les cales d'espacement dans les intervalles 22 entre substrats voisins ou entre substrat et paroi voisine comportent une cale annulaire 40, s'étendant à proximité ou en bordure du périmètre extérieur des substrats, et des cales radiales 44.

Les cales annulaires 40 obturent les intervalles 22 tout en ménageant des passages de fuite dans une partie au moins de ces intervalles. Les cales radiales 44 contribuent à assurer un maintien satisfaisant des préformes 20 et à conférer une hauteur sensiblement constante à chaque intervalle 22. Elles pourront être omises si la rigidité des préformes le permet.

L'aménagement des cales annulaires 40 pour former des passages de fuite peut être réalisé de différentes façons.

Les cales 40 peuvent être réalisées en plusieurs secteurs annulaires 40a, 40b,... non jointifs ménageant des passages de fuite 41 entre leurs extrémités (figure 8).

En variante (figure 9), les cales annulaires 40 peuvent être réalisées en une seule pièce, les passages de fuite 41 étant constitués par des perçages radiaux formés à travers les cales.

Encore en variante (figure 10), les cales annulaires 40 peuvent être réalisées en une seule pièce, les passages de fuite 41 étant constitués par des encoches formées dans leur bord supérieur et/ou dans leur bord inférieur.

La figure 11 illustre encore une autre disposition possible des cales d'espacement. Dans chaque intervalle 22, les cales d'espacement comprennent une pluralité de cales annulaires 40₁, 40₂, 40₃ discontinues ou présentant des perçages radiaux ou encoches. De préférence, une cale annulaire en une seule pièce ou formée d'une succession de secteurs annulaires est prévue à proximité de chacun des périmètres intérieur et extérieur des substrats 20.

Les passages de fuite 41₁ sont définis par l'aménagement de la cale annulaire externe 40₁, c'est-à-dire soit par des espaces entre extrémités de secteurs annulaires voisins, soit par des perçages radiaux, soit par des encoches. Les cales 40₂ et 40₃ ménagent également des passages 41₂ et 41₃ mais ceux-ci sont de préférence de plus grandes dimensions que les passages 41₁. On peut prévoir pour les passages de fuite des dimensions décroissantes à partir du périmètre interne des substrats, afin d'alimenter suffisamment les intervalles 22 en phase gazeuse.

Pour définir les sections du ou des passages de fuite, il peut être procédé de la façon suivante.

Pour un chargement donné de substrats poreux à densifier, on détermine la relation entre la différence de pression ΔP entre les volumes interne 24 et externe 26 et le débit de phase gazeuse admise dans l'enceinte, et ce pour différentes valeurs de section de fuite globale S, la section de fuite globale étant la somme des sections individuelles des passages de fuite.

Cette détermination est effectuée avec des substrats à l'état non densifié, c'est-à-dire présentant leur porosité maximale pour obtenir une relation entre la valeur initiale ΔP₀ de la différence de pression et la section de fuite globale S.

Par ailleurs, selon le type particulier d'infiltration chimique en phase vapeur à réaliser, à savoir nature de la phase gazeuse réactionnelle, nature du matériau de matrice à déposer au sein de la porosité des substrats, et température à laquelle l'infiltration est réalisée, on détermine un seuil maximal de pression admissible Pₘₐₓ pour la phase gazeuse ou pour la pression partielle de précurseur(s) gazeux contenu(s) dans la phase gazeuse. Le seuil maximal de pression admissible Pₘₐₓ est notamment celui au-delà duquel une modification non désirée de structure du matériau de matrice déposé est susceptible de se produire, ou la formation de dépôts parasites indésirables est susceptible de se produire.

La valeur globale S de section de fuite est alors choisie telle que Sₘᵢₙ ≦ S ≦ Sₘₐₓ, OÙ
- Sₘₐₓ est la valeur maximale de section de fuite au-delà de laquelle le gradient de pression est insuffisant au début de la densification, et
- Sₘᵢₙ est la valeur minimale de section de fuite en deçà de laquelle le gradient de pression existant en fin du processus de densification est tel que le seuil maximal admissible de pression Pₘₐₓ est dépassé.

Sₘₐₓ est déterminée à partir des relations préétablies entre ΔP₀ et S pour différents débits de phase gazeuse et différentes valeurs de S. On choisit de préférence pour Sₘₐₓ une valeur correspondant à un gradient de pression ΔP₀ au moins égal à 15 % de la valeur maximale ΔP₀ₘₐₓ existant en l'absence de passages de fuite (S = 0).

On choisit de préférence pour Sₘᵢₙ une valeur correspondant à un gradient de pression ΔP₀ au plus égal à 85 % de la valeur maximale ΔP₀ₘₐₓ existant en l'absence de passages de fuite (S = 0).

La valeur de ΔP₀ par rapport à ΔP₀ₘₐₓ dépend notamment de la géométrie et de la perméabilité initiale des substrats à densifier. Une perméabilité initiale relativement élevée impose une valeur de ΔP₀ plus proche de ΔP₀ₘₐₓ pour garantir un gradient de pression dès le début du processus de densification.

### Exemple

Un exemple de détermination de la section de fuite globale S sera donné ci-après dans le cas d'un chargement de substrats annulaires constituant des préformes de disques de frein en carbone.

Le chargement était formé de 23 substrats empilés exempts de toute densification. Chaque substrat était constitué d'une pluralité de nappes fibreuses en fibres de carbone aiguilletées entre elles. La réalisation de préformes de ce type pour des disques de frein destinés à l'aéronautique ou à la compétition automobile est bien connue. Les substrats présentaient un diamètre intérieur de 26 cm, un diamètre extérieur de 48 cm, une hauteur (épaisseur) de 3,6 cm et un taux volumique de fibres de 23 % (pourcentage du volume des disques occupé par les fibres).

Il a d'abord été réalisé une mesure du gradient de pression entre l'intérieur et l'extérieur de la pile, pour différents débits de gaz admis, en utilisant des cales d'espacement annulaires pleines ne ménageant aucun passage de fuite (S = 0), c'est-à-dire dans une situation d'infiltration avec flux forcé tel que décrit dans le document précité EP 0 792 385. La mesure a été effectuée à froid en utilisant un gaz neutre, en l'espèce de l'azote. La courbe A de la figure 12 montre la relation mesurée entre la différence de pression ΔP₀ et le débit gazeux admis.

Ensuite, des mêmes mesures ont été réalisées pour différentes sections de fuite. Les courbes B, C, D, E montrent les relations établies pour des valeurs de S égales respectivement à 2,4 cm², 6 cm², 12,6 cm² et 30 cm².

Les courbes de la figure 12 montrent que, quel que soit le débit de gaz admis, la valeur de S doit être choisie inférieure à environ 25 cm², pour avoir une valeur ΔP₀ au moins égale à 15 % de la valeur maximale obtenue sans section de fuite (S = 0), et supérieure à environ 2 cm² pour avoir une valeur ΔP₀ au plus égale à 85 % de la valeur maximale obtenue sans section de fuite (S = 0).

La valeur de section de fuite globale étant choisie, sa répartition en sections individuelles de passages de fuite peut être réalisée de plusieurs façons.

Les sections individuelles des passages de fuite peuvent être égales ou non.

Il est possible de prévoir des passages de fuite au niveau de chacun des intervalles 22 ou au niveau de certains seulement de ces intervalles, par exemple un sur deux.

Il est possible de prévoir des sections individuelles de passages de fuite telles que la section de fuite globale soit répartie uniformément sur toute la hauteur de l'empilement.

Il pourra toutefois être préféré, pour tenir compte de la perte de charge entre l'extrémité de la pile où est introduite la phase gazeuse et l'extrémité opposée, de répartir la section de fuite globale de façon non uniforme, et plus particulièrement dans le sens croissant entre le bas et le haut de la pile. Cela pourra être réalisé en augmentant progressivement le nombre et/ou la section des passages de fuite individuels sur la hauteur de l'empilement.

Il est encore possible de ne prévoir qu'un nombre restreint de passages de fuite, voire même un seul passage de fuite ayant la section voulue.

Les figures 13 et 14 illustrent une variante de mise en œuvre du procédé montré par les figures 7 et 8.

Le chargement des figures 13 et 14 diffère de celui des figures 7 et 8 en ce que des passages de fuite 41 sont ménagés au niveau d'une seule cale d'espacement 40, par exemple du type de celle illustrée par la figure 9, les autres cales d'espacement 42 étant pleines, c'est-à-dire ne ménageant pas de passages de fuite.

La cale 40 peut avoir une épaisseur supérieure à celle des cales 42 afin de pouvoir ménager un ou, de préférence, plusieurs passages de fuite 41 offrant la section totale de fuite voulue.

La cale 40 peut être placée à n'importe quel niveau de la pile, entre deux substrats ou entre un substrat et un plateau support 11 ou 12. Elle peut être complétée par des tronçons de cale radiaux 44 (figure 14).

Il n'est toutefois pas nécessaire que le ou les passages de fuite soient formés au niveau d'une ou de plusieurs cales d'espacement.

Ainsi, dans le mode de réalisation des figures 15 et 16, un ou plusieurs passages de fuite 51 sont formés dans la paroi 19 qui canalise la phase gazeuse dans la zone de préchauffage entre l'entrée dans l'enceinte et l'entrée dans le volume interne de la pile de substrats. Dans l'exemple illustré, comme montré par la figure 16, plusieurs passages 51 sont formés en étant répartis autour de la paroi 19. Un seul passage pourrait être prévu.

La figure 17 illustre un autre mode de réalisation selon lequel un passage de fuite 61 est formé dans la paroi 25 obturant le volume interne de la pile de substrats à son extrémité supérieure. Bien qu'un seul passage 61 soit représenté, on pourra bien entendu prévoir plusieurs passages formés dans la paroi 25.

Dans les modes de réalisation des figures 15 et 17, les cales d'espacement 42 sont des cales pleines n'aménageant pas de passages de fuite, de sorte que les fuites volontairement introduites se situent au seul niveau de la paroi 19 ou de la paroi 25.

Bien entendu, les différents modes de réalisation pourront être combinés en prévoyant des passages de fuite au niveau de la paroi 19 et/ou au niveau d'une ou plusieurs cales d'espacement et/ou au niveau de la paroi 25.

On notera qu'en raison des problèmes mentionnés plus haut que pose la réalisation de passages de fuite au niveau de chaque cale d'espacement, le mode de réalisation de la figure 7 n'est pas préféré dans le cas d'un nombre relativement grand de substrats empilés.

### Essai 1 (comparatif)

Le chargement de substrats tel que décrit ci-avant a été densifié par infiltration chimique en phase vapeur avec flux forcé, c'est-à-dire sans aménager de passage de fuite entre substrats empilés, le mode opératoire étant conforme à celui décrit dans le document EP-0 792 385. On a utilisé une phase gazeuse réactive contenant un mélange de méthane et propane en tant que précurseur de carbone. Le débit de phase gazeuse était fixé à environ 70 l/minute et la pression Pₑₓₜ dans l'enceinte à l'extérieur de la pile de substrats était d'environ 14 mbar.

La valeur de pression Pᵢₙₜ à l'intérieur de la pile a été mesurée pendant le processus de densification des substrats. La courbe F de la figure 18 montre la variation de cette pression Pᵢₙₜ en fonction du temps.

Après 200 h, le processus a été interrompu car la pression interne Pᵢₙₜ avait atteint le seuil maximal de pression admissible Pₘₐₓ au-delà de laquelle se produit un changement de microstructure et la formation de suies. Le disques obtenus étaient incomplètement densifiés, leur densité moyenne étant de 1,44 et pouvant localement descendre à 1,2.

Les mesures de Pᵢₙₜ et Pₑₓₜ sont effectuées au moyen de capteurs situés respectivement dans le passage d'entrée de la phase gazeuse dans l'enceinte et dans le passage de sortie de phase gazeuse résiduelle hors de l'enceinte, à travers le couvercle 10b.

### Essai 2 (comparatif)

Un chargement de substrats tel que décrit précédemment a été densifié par infiltration chimique en phase vapeur avec flux dirigé conformément au procédé décrit dans le document US 5 904 957. On a utilisé la même phase réactive que dans l'essai 1, avec le même débit de phase gazeuse et la même pression Pₑₓₜ dans l'enceinte à l'extérieur de la pile de substrats. La pression Pᵢₙₜ dans la pile est restée constante et égale à Pₑₓₜ (courbe G de la figure 18). Après 250 h, la densité moyenne des disques obtenus était de 1,19.

### Essai 3 (selon l'invention)

Un chargement de substrats tel que décrit précédemment a été densifié par infiltration chimique en phase vapeur en utilisant des cales d'espacement telles que celle de la figure 9 aménageant des passages de fuite entre substrats empilés, chaque cale présentant 6 passages de fuite. La section globale de fuite offerte par les passages de fuite était de 11 cm² pour que le gradient de pression ΔP₀ corresponde à 50 % de la valeur maximale ΔPₘₐₓ existant en l'absence de fuite (S=0). On a utilisé la même phase réactive que dans l'essai 1, avec le même débit de phase gazeuse et la même pression Pₑₓₜ dans l'enceinte, à l'extérieur de la pile de substrats.

La valeur de pression Pᵢₙₜ à l'intérieur de la pile a été mesurée pendant le processus de densification des substrats qui a été conduit pendant 250 h. La courbe H de la figure 18 montre la variation de cette pression Pᵢₙₜ en fonction du temps. Pendant les 250 h du processus, la pression interne Pᵢₙₜ augmente plus lentement que dans l'essai 1. A 250 h, la densité moyenne des disques obtenus était de 1,47. La pression interne Pᵢₙₜ étant de 19,7 mbar au bout de 250 h, il aurait été possible de poursuivre la densification, sans risquer rapidement un changement de microstructure et la formation de suies, afin d'obtenir une densité plus élevée.

### Essai 4 (selon l'invention)

On a procédé comme dans l'essai 3, mais en utilisant des cales d'espacement munies chacune de deux trous formant passages de fuite. La section globale de fuite offerte était de 3,6 cm².

La courbe I de la figure 18 montre la variation de la pression Pᵢₙₜ en fonction du temps. A 250 h, la densité moyenne des disques obtenus était de 1,47.

### Essai 5 (selon l'invention)

On a procédé comme dans l'essai 3 mais en utilisant des cales d'espacement entre substrats empilés ne ménageant pas de passage de fuite et en réalisant des passages de fuite par perçage de la paroi 19 de la zone de préchauffage comme dans le mode de réalisation des figures 15 et 16. La section globale de fuite offerte était de 2,35 cm².

La courbe J de la figure 18 montre la variation de la pression Pᵢₙₜ en fonction du temps. A 250 h, la densité moyenne des disques obtenus était de 1,48.

Les essais 3, 4 et 5 montrent non seulement la supériorité du procédé selon l'invention par rapport aux procédés de l'art antérieur, mais aussi que la localisation et la réalisation du ou des passages de fuite créés n'a pratiquement pas d'influence.

La variation de la densité des substrats en fonction du temps a été évaluée lors de processus tels que ceux des essais 1, 2 et 3. Les courbes K, L et M de la figure 19 illustrent les cinétiques de densification respectivement avec la densification à flux forcé, la densification à flux dirigé et la densification réalisée conformément à l'invention.

La comparaison des courbes K, L et M permet aussi de montrer l'intérêt d'un procédé selon l'invention. En effet, une augmentation importante de la cinétique de densification par rapport au procédé de densification à flux dirigé est obtenue. La densité moyenne du chargement atteint 1,50 en 260 h avec le procédé mis en oeuvre selon l'invention alors que, pour la même durée, elle n'est que de 1,19 avec le procédé de densification à flux dirigé. Il faudrait environ 430 h pour atteindre une densité de 1,50 avec ce dernier procédé. Ce résultat a été obtenu avec le procédé conforme à l'invention sans rencontrer de suies ni de changement de microstructure indésirable.

La comparaison avec le procédé de densification à flux forcé montre que la cinétique de densification est légèrement plus lente avec le procédé conforme à l'invention. Cependant, il est possible d'atteindre une densité plus élevée avec le procédé selon l'invention car le seuil de pression maximal Pₘₐₓ n'est jamais dépassé contrairement à ce qui est rencontré avec le procédé de densification à flux forcé. Pour ce dernier procédé, la densité maximale atteinte est de 1,44.

En conclusion, à phase gazeuse, pression à l'extérieur de la pile, débit et température égaux, le procédé selon l'invention permet une densification beaucoup plus rapide que le procédé de densification à flux dirigé et plus complète bien qu'un peu moins rapide que le procédé de densification à flux forcé. Le procédé selon l'invention permet de plus de supprimer les risques de changement de microstructure et de formation de suies inhérents à l'utilisation du procédé de densification à flux forcé.

Bien que l'exemple décrit ci-avant concerne un type particulier de substrat et un type particulier de phase gazeuse réactive pour obtenir un matériau de matrice particulier souhaité, il apparaîtra immédiatement à l'homme de l'art que le processus de détermination des valeurs Sₘᵢₙ et Sₘₐₓ est aisément transposable à tout type de substrat présentant un passage central et tout processus de densification par infiltration chimique en phase vapeur.

La figure 20 illustre un mode d'application d'un procédé conforme à l'invention pour la densification d'un substrat poreux constituant une préforme de divergent de tuyère de moteur fusée.

Le substrat 120 est disposé à l'intérieur d'une enceinte 110 délimitée par un induit 114 chauffé par couplage avec un inducteur (non représenté). Comme indiqué plus haut, le chauffage du substrat 120 pourra en variante être réalisé par couplage inductif direct avec un inducteur. Toujours en variante, le chauffage de la paroi 114 pourra être de type résistif.

L'enceinte 110 est alimentée en phase gazeuse réactive à travers son fond 110a. La phase gazeuse admise traverse une zone de préchauffage 118 formée de plateaux perforés situés les uns au-dessus des autres.

En sortie de la zone de préchauffage 118, la phase gazeuse est canalisée vers le volume interne 124 constitué par le passage central du substrat 120. A son extrémité supérieure, le volume 124 est obturé par un couvercle 125 reposant sur le substrat 120 et surmonté d'un poids 125a permettant de le maintenir en place.

Le substrat 120 est supporté par un plateau 111 présentant un passage central et surmontant la zone de préchauffage 118. Des cales d'espacement annulaires 140 ménagent des intervalles 122 entre le plateau support 111 et une extrémité du substrat 120 et entre l'autre extrémité de la préforme et le couvercle 125. Les cales 140 sont aménagées pour former des passages de fuite entre le volume 124 et le volume 126 extérieur au substrat 120 dans l'enceinte 110.

La phase gazeuse admise dans l'enceinte circule du volume 124 vers le volume 126, en passant à travers la porosité du substrat 120 et à travers les passages de fuite ménagés dans les intervalles 122.

La phase gazeuse résiduelle est extraite à partir du volume 126 à travers un passage formé dans le couvercle 110b de l'enceinte et communiquant avec des moyens d'aspiration (non représentés).

Les passages de fuite pourront être aménagés de différentes façons, par exemple en réalisant les cales annulaires 140 sous forme de plusieurs secteurs annulaires non jointifs, ou en réalisant les cales annulaires en une seule pièce avec des perçages radiaux 141 (exemple illustré) ou des encoches, de la même façon que décrit plus haut en référence aux figures 8, 9 et 10.

La détermination de la section de fuite globale offerte par les passages de fuite est réalisée sur le même principe que celui décrit plus haut, de manière à établir un gradient de pression entre les volumes 124 et 126 dès le début du processus de densification mais sans excéder une valeur de pression maximale admissible dans le volume 124 en fin du processus de densification.

En variante, la phase gazeuse pourra être canalisée vers le volume externe 126 et circuler de l'extérieur vers l'intérieur de la préforme, la phase gazeuse résiduelle étant extraite à partir du volume interne 124. Le volume externe 126 est alors obturé à son extrémité opposée à celle où la phase gazeuse est admise.

Encore en variante, la circulation de la phase gazeuse pourra être réalisée du haut vers le bas de l'enceinte.

La figure 21 illustre encore un autre mode de mise en oeuvre d'un procédé selon l'invention pour la densification de substrats poreux constituant des préformes de divergents de tuyères de moteurs fusées. Les éléments correspondant à ceux du mode de réalisation de la figure 20 portent les mêmes références, par souci de simplicité.

Plusieurs substrats 120 sont disposés dans la même enceinte avec leurs passages axiaux alignés verticalement. Le substrat disposé en partie inférieure repose sur le plateau 111, tandis que les autres substrats reposent sur des plateaux intermédiaires annulaires 112. Les substrats sont partiellement engagés les uns dans les autres et les plateaux 112 entourent la pile de substrats tout en présentant des ouvertures 113 pour assurer la continuité du volume 126 extérieur aux substrats dans l'enceinte 110.

La phase gazeuse issue de la zone de préchauffage 118 est canalisée vers le volume extérieur 126 à travers des ouvertures 113 du plateau 111. Le volume 126 est obturé par un couvercle 127 à son extrémité opposée à celle où la phase gazeuse est admise. Le couvercle 127 repose sur le substrat situé en haut de la pile. Il est muni d'une ouverture centrale 128 qui communique avec l'intérieur de la pile de substrats 120. Le couvercle 127 s'étend jusqu'à la paroi 114 de l'enceinte 110 et est fixé à cette paroi de façon étanche.

La phase gazeuse circule du volume extérieur 126 vers le volume intérieur 124 formé par les passages centraux alignés des substrats en passant à travers la porosité des substrats 120 et, en dehors de ceux-ci, à travers des passages de fuite. Des passage de fuite sont définis par les espaces 115 entre les bords internes des plateaux intermédiaires 112 et les faces extérieures des substrats 120 entourés par ces plateaux.

Des passages de fuite supplémentaires 141 pourront être aménagés au moyen de cales d'espacement 140 intercalées entre le substrat inférieur et le plateau de support 111 et/ou entre le substrat supérieur et le couvercle 127, comme dans le mode de réalisation de la figure 15.

La phase gazeuse résiduelle est extraite hors du volume interne 124 par aspiration à travers l'ouverture 128 du couvercle 127 et à travers le couvercle 110b de l'enceinte.

La section globale de fuite offerte par les passages de fuite est déterminée comme indiqué précédemment pour garantir, d'une part, l'existence d'un gradient de pression au début du processus de densification et, d'autre part, le non-dépassement de la pression maximale pour la phase gazeuse dans le volume externe 126.

La répartition de la section globale de fuite sur la hauteur de l'empilement pourra être réalisée de façon uniforme ou non uniforme. Dans ce dernier cas, la répartition sera de préférence en sens croissant dans la direction générale d'écoulement de la phase gazeuse dans l'enceinte.

On notera qu'avec la disposition illustrée des substrats 120, et une admission de la phase gazeuse à la partie inférieure de l'enceinte, il est préférable de faire circuler la phase gazeuse de l'extérieur vers l'intérieur de la pile pour qu'elle parcoure l'intégralité des faces des substrats.

Une circulation de la phase gazeuse de l'intérieur vers l'extérieur de la pile de substrats pourrait être envisagée avec une admission de la phase gazeuse à la partie supérieure de l'enceinte.

La figure 22 illustre une application d'un procédé selon l'invention pour la densification d'un substrat poreux destiné à la fabrication d'un col de tuyère de moteur fusée.

Le substrat 220 de forme cylindrique annulaire est disposé à l'intérieur d'une enceinte 210 qui est délimitée par une paroi 214 et dans laquelle est logé un inducteur 216 entourant le substrat 220. Le substrat 220 est supporté par un plateau 221 disposé au-dessus du fond 210a de l'enceinte 210.

L'enceinte 210 est alimentée en phase gazeuse réactive à travers le fond 210a. La phase gazeuse admise est canalisée vers le volume interne 224 constitué par le passage central du substrat 220 en passant dans un conduit entouré par une paroi 219 reliant l'entrée de phase gazeuse dans l'enceinte à un passage central du plateau support 221.

A son extrémité supérieure, le volume interne 224 est obturé par un couvercle 225 reposant sur le substrat 220 et surmonté d'un poids 225a permettant de le maintenir en place.

Des cales d'espacement annulaires 240 sont interposées entre le plateau support 221 et une extrémité du substrat 220 et entre l'autre extrémité du substrat 220 et le couvercle 225. Les cales 240 sont aménagées, par exemple percées radialement, pour former des passages de fuite 241 entre le volume 224 et le volume 226 extérieur au substrat 220 dans l'enceinte 210.

La phase gazeuse admise dans l'enceinte circule du volume 224 vers le volume 226 en passant à travers la porosité du substrat 220 et, en dehors de celui-ci, à travers les passages de fuite 241 des cales 240. La phase gazeuse résiduelle est extraite du volume 226 à travers un passage formé dans le couvercle 210b de l'enceinte 210.

Le chauffage du substrat 220 est réalisé par couplage inductif direct avec l'inducteur 216, ce qui a pour effet d'engendrer un gradient de température au sein du substrat entre une partie interne de celui-ci et ses surfaces externes exposées. La densification est favorisée initialement dans la partie interne plus chaude de la préforme et progresse ensuite vers les parties externes. L'existence d'un gradient de pression favorise aussi l'accès de la phase gazeuse vers l'intérieur du substrat.

La combinaison d'un gradient de pression et d'un gradient de température est donc particulièrement favorable pour réaliser une bonne densification à cœur de substrats poreux annulaires épais tels que des substrats destinés à la réalisation de cols de tuyère. Il en résulte un avantage important pour cette application particulière puisque après densification l'usinage réalisé pour obtenir le col de tuyère laisse subsister la partie centrale du substrat densifié (comme montré en traits interrompus sur la figure 22).

On notera que les processus de densification de substrats poreux annulaires avec chauffage par couplage direct entre inducteur et substrats sont connus. On peut se référer aux documents WO 98/17599 et WO 95/11869 par exemple.

La figure 23 illustre une application d'un procédé selon l'invention pour la densification simultanée de plusieurs substrats poreux annulaires destinés à la fabrication de cols de tuyères de moteurs fusées. Les éléments correspondants à ceux du mode de réalisation de la figure 22 portent les mêmes références, par souci de simplicité.

Plusieurs substrats 220 de forme cylindrique annulaire sont disposés dans la même enceinte 210 avec leurs passages axiaux alignés verticalement. Le substrat disposé en partie inférieure repose sur le plateau 211 tandis que les autres substrats reposent sur des plateaux intermédiaires annulaires 212.

La phase gazeuse admise à la partie inférieure de l'enceinte 210 est canalisée par la paroi 219 vers le volume intérieur 224 constitué par les passages centraux alignés des substrats 220 et des plateaux supports 211, 212. A son extrémité supérieure, le volume 224 est obturé par un couvercle 225 qui peut être surmonté d'un poids 225a. Des cales d'espacement annulaires 240 sont interposées entre les extrémités des substrats 220 et les plateaux 211, 212 ou couvercle 225. Les cales 240 sont aménagées, par exemple percées radialement, pour former des passages de fuite 241 entre le volume 224 et le volume 226 extérieur à la pile de substrats 220 dans l'enceinte 210.

La phase gazeuse circule du volume 224 vers le volume 226 à travers la porosité des substrats 220 et, en dehors de ceux-ci, à travers les passages de fuite 241, avant d'être évacuée hors de l'enceinte 210 à travers un passage formé dans le couvercle 210b de celle-ci.

Le chauffage des substrats est assuré par couplage inductif direct avec l'inducteur 216 qui entoure la pile de substrats 220 dans l'enceinte, à l'intérieur de la paroi latérale 214. L'inducteur 216 peut être partagé en plusieurs sections 216a, 216b, 216c situées aux niveaux des différents substrats 220 empilés. Les sections d'inducteurs peuvent être alimentées séparément.

Comme dans le mode de réalisation de la figure 22, la densification des substrats est effectuée en combinant des modes à gradient de température et à gradient de pression.

Dans les modes de réalisation des figures 22 et 23, la section globale de fuite est déterminée en appliquant le même principe que celui décrit plus haut, de manière à établir un gradient de pression entre les volumes 224 et 226 au début du processus de densification mais sans excéder une valeur de pression maximale admissible dans le volume 224 en fin du processus de densification.

Bien entendu, on pourra conférer aux cales annulaires 240 différentes formes de réalisation, par exemple comme montré par les figures 8 et 10. En outre, les passages de fuite pourront être ménagés non pas au niveau de cales d'espacement, mais dans la paroi 219 et/ou dans le couvercle 225.

On notera encore que la canalisation de la phase gazeuse admise pourra être réalisée vers le volume externe 226, la phase gazeuse circulant alors de l'extérieur vers l'intérieur du substrat 220 ou de la pile de substrats 220. Le volume externe est alors fermé à son extrémité opposée à celle où la phase gazeuse est admise.

En outre, la circulation de la phase gazeuse pourra être réalisée du haut vers le bas de l'enceinte.

## Revendications

1. Procédé pour la densification par infiltration chimique en phase gazeuse d'au moins un substrat présentant un passage central, le procédé comportant les étapes qui consistent à :
- disposer à l'intérieur d'une enceinte un ou plusieurs substrats pour délimiter dans l'enceinte un volume interne formé essentiellement par le passage central du substrat ou les passages centraux de plusieurs substrats alignés, et un volume externe formé essentiellement par l'extérieur du ou des substrats,
- aménager volontairement au moins un passage de fuite faisant communiquer lesdits volumes entre eux en dehors du ou des substrats,
- admettre dans l'enceinte une phase gazeuse contenant au moins un précurseur gazeux d'un matériau de matrice à déposer au sein de la porosité du ou des substrats,
- canaliser la phase gazeuse vers l'un, ou premier, des volumes interne et externe, ledit premier volume étant fermé à une extrémité opposée à celle où est admise la phase gazeuse, et
- extraire la phase gazeuse résiduelle hors de l'enceinte à partir de l'autre, ou deuxième, des volumes interne et externe, de sorte que la phase gazeuse circule dans l'enceinte du premier volume au deuxième volume en diffusant à travers la porosité du ou des substrats et en passant à travers le ou chaque passage de fuite,
**caractérisé en ce que** :
- on confère à la section totale du ou des passages de fuite une valeur telle que la différence de pression entre le premier et le deuxième volume au début du processus de densification soit au moins égale à 15 % et au plus égale à 85 % de la valeur de différence de pression obtenue en l'absence de passages de fuite.

2. Procédé selon la revendication 1, **caractérisé en ce que** l'on forme à l'intérieur de l'enceinte au moins une pile de substrats avec leurs passages centraux alignés en ménageant des espaces entre substrats adjacents au moyen de cales d'espacement, lesdits volumes interne et externe étant constitués par respectivement l'intérieur et l'extérieur de la ou des piles, et l'on aménage au moins une des cales d'espacement pour former le ou les passages de fuite.

3. Procédé selon la revendication 2, **caractérisé en ce que** l'on utilise au moins une cale annulaire munie d'au moins un passage radial formant passage de fuite.

4. Procédé selon la revendication 2, **caractérisé en ce que** l'on utilise au moins une cale en plusieurs parties ménageant entre elles des passages de fuite.

5. Procédé selon l'une quelconque des revendications 2 à 4, **caractérisé en ce que** l'on aménage plusieurs cales d'espacement pour former des passages de fuite, et l'on répartit la section totale des passages de fuite de façon non uniforme sur la hauteur de la ou chaque pile.

6. Procédé selon la revendication 5, **caractérisé en ce que** la section de fuite entre substrats varie en sens croissant entre l'extrémité du premier volume où est admise la phase gazeuse et l'extrémité opposée.

7. Procédé selon l'une quelconque des revendications 1 à 6, **caractérisé en ce que** l'on aménage au moins un passage de fuite sur le trajet de canalisation de la phase gazeuse entre l'entrée de la phase gazeuse dans l'enceinte et l'entrée dans ledit premier volume.

8. Procédé selon la revendication 7, **caractérisé en ce que** l'on aménage au moins un passage de fuite au niveau d'une zone de préchauffage de la phase gazeuse.

9. Procédé selon l'une quelconque des revendications 1 à 8, **caractérisé en ce que** l'on aménage au moins un passage de fuite à travers une paroi de fermeture dudit premier volume à son extrémité opposée à celle où est admise la phase gazeuse.

10. Procédé selon l'une quelconque des revendications 1 à 9, **caractérisé en ce que** le ou chaque substrat est chauffé dans l'enceinte de façon sensiblement uniforme.

11. Procédé selon l'une quelconque des revendications 1 à 9, **caractérisé en ce que** le ou chaque substrat est chauffé dans l'enceinte avec établissement d'un gradient de température au sein du substrat.

12. Procédé selon la revendication 11, **caractérisé en ce que** le ou chaque substrat est chauffé par couplage inductif direct avec un inducteur.

13. Procédé selon l'une quelconque des revendications 2 à 12, **caractérisé en ce que** l'on dispose à l'intérieur de l'enceinte des substrats annulaires fibreux constituant des préformes de disques de frein.

14. Procédé selon l'une quelconque des revendications 1 à 12, **caractérisé en ce que** l'on dispose à l'intérieur de l'enceinte un ou plusieurs substrats fibreux constituant une ou plusieurs préformes de divergent de tuyère.

15. Procédé selon l'une quelconque des revendications 1 à 12, **caractérisé en ce que** l'on dispose à l'intérieur de l'enceinte un ou plusieurs substrats fibreux destinés à la réalisation de cols de tuyère.

## Patentansprüche

1. Verfahren zur Verdichtung zumindest eines Substrats, das einen zentralen Durchgang aufweist, durch chemische Gasphasen-Infiltration, wobei das Verfahren die folgenden Schritte umfasst:
- Anordnen eines oder mehrerer Substrate im Inneren einer Einhausung, um in der Einhausung ein inneres Volumen, das im Wesentlichen durch den zentralen Durchgang des Substrats oder die zentralen Durchgänge mehrerer ausgerichteter Substrate gebildet wird, und ein äußeres Volumen zu begrenzen, das im Wesentlichen durch das Äußere des oder der Substrate gebildet wird,
- beliebiges Einbringen zumindest eines Austrittsdurchgangs, der außerhalb des oder der Substrate die Volumen miteinander in Kommunikation setzt,
- Einlassen einer Gasphase, die zumindest einen gasförmigen Vorläufer eines Matrixmaterials enthält, das in den Poren des oder der Substrate abgeschieden werden soll, in die Einhausung,
- Leiten der Gasphase zu dem einen oder ersten der inneren und äußeren Volumen, wobei das erste Volumen an einem Ende, das jenem entgegengesetzt ist, in welches die Gasphase eingelassen wird, geschlossen ist, und
- Abziehen der restlichen Gasphase aus der Einhausung ausgehend von dem anderen oder zweiten der inneren und äußeren Volumen auf solche Weise, dass die Gasphase in der Einhausung von dem ersten Volumen zu dem zweiten Volumen zirkuliert, wobei sie durch die Poren des oder der Substrate diffundiert und durch den oder jeden Austrittsdurchgang strömt,
**dadurch gekennzeichnet, dass**:
der Gesamtquerschnitt des oder der Austrittsdurchgänge einen solchen Wert erhält, dass die Druckdifferenz zwischen dem ersten und dem zweiten Volumen am Beginn des Verdichtungsvorgangs zumindest gleich 15 % und höchstens gleich 85 % des Werts der Druckdifferenz ist, die bei Fehlen der Austrittsdurchgänge erhalten wird.

2. Verfahren nach Anspruch 1, **dadurch gekennzeichnet, dass** im Inneren der Einhausung zumindest ein Stapel von Substraten gebildet wird, wobei deren zentrale Durchgänge ausgerichtet sind und Zwischenräume zwischen benachbarten Substraten mittels Distanzblöcken vorgesehen werden und die inneren und äußeren Volumen jeweils aus dem Inneren und dem Äußeren des oder der Stapel bestehen, und zumindest einer der Distanzblöcke vorgesehen wird, um den oder die Austrittsdurchgänge zu bilden.

3. Verfahren nach Anspruch 2, **dadurch gekennzeichnet, dass** zumindest ein ringförmiger Block verwendet wird, der mit zumindest einem radialen Durchgang versehen ist, der den Austrittsdurchgang bildet.

4. Verfahren nach Anspruch 2, **dadurch gekennzeichnet, dass** zumindest ein Block aus mehreren Teilen verwendet wird, die zwischen sich Austrittsdurchgänge vorsehen.

5. Verfahren nach einem der Ansprüche 2 bis 4, **dadurch gekennzeichnet, dass** mehrere Distanzblöcke vorgesehen werden, um Austrittsdurchgänge zu bilden, und der Gesamtquerschnitt der Austrittsdurchgänge auf nicht gleichmäßige Weise über die Höhe des oder jedes Stapels verteilt wird.

6. Verfahren nach Anspruch 5, **dadurch gekennzeichnet, dass** der Austrittsquerschnitt zwischen Substraten auf zwischen dem Ende des ersten Volumens, an welchem die Gasphase eingelassen wird, und dem entgegengesetzten Ende zunehmende Weise variiert.

7. Verfahren nach einem der Ansprüche 1 bis 6, **dadurch gekennzeichnet, dass** zumindest ein Austrittsdurchgang an dem Verlauf der Leitung der Gasphase zwischen dem Eintritt der Gasphase in die Einhausung und dem Eintritt in das erste Volumen eingebracht wird.

8. Verfahren nach Anspruch 7, **dadurch gekennzeichnet, dass** zumindest ein Austrittsdurchgang im Bereich einer Vorheizzone der Gasphase eingebracht wird.

9. Verfahren nach einem der Ansprüche 1 bis 8, **dadurch gekennzeichnet, dass** zumindest ein Austrittsdurchgang durch eine Verschlusswand des ersten Volumens eingebracht wird, an dessen Ende, das jenem entgegengesetzt ist, an dem die Gasphase eingelassen wird.

10. Verfahren nach einem der Ansprüche 1 bis 9, **dadurch gekennzeichnet, dass** das oder jedes Substrat in der Einhausung auf im Wesentlichen gleichmäßige Weise erhitzt wird.

11. Verfahren nach einem der Ansprüche 1 bis 9, **dadurch gekennzeichnet, dass** das oder jedes Substrat in der Einhausung unter Herstellung eines Temperaturgradienten innerhalb des Substrats erhitzt wird.

12. Verfahren nach Anspruch 11, **dadurch gekennzeichnet, dass** das oder jedes Substrat durch direkte induktive Kopplung mit einem Induktor erhitzt wird.

13. Verfahren nach einem der Ansprüche 2 bis 12, **dadurch gekennzeichnet, dass** im Inneren der Einhausung ringförmige Fasersubstrate angeordnet werden, die Vorformlinge für Bremsscheiben bilden.

14. Verfahren nach einem der Ansprüche 1 bis 12, **dadurch gekennzeichnet, dass** im Inneren der Einhausung ein oder mehrere Fasersubstrate angeordnet werden, die einen oder mehrere Vorformlinge für Düsenerweiterungen bilden.

15. Verfahren nach einem der Ansprüche 1 bis 12, **dadurch gekennzeichnet, dass** im Inneren der Einhausung ein oder mehrere Fasersubstrate angeordnet werden, die für die Verwirklichung von Düsenverengungen bestimmt sind.

## Claims

1. A chemical vapor infiltration method for densifying at least one substrate having a central passage, the method comprising the steps consisting in:
- placing one or more substrates inside an enclosure to define within the enclosure an inside volume formed essentially by the central passage of the substrate or the central passages of a plurality of substrates in alignment, and an outer volume formed essentially by the outside of the substrate(s);
- voluntarily arranging at least one leakage passage putting said volumes into communication with each other other than through the substrates;
- admitting into the enclosure a gas containing at least one gaseous precursor of a matrix material to be deposited within the pores of the substrate(s);
- channeling the gas towards a first one of the inside and outer volumes, said first volume being closed at an end opposite from the end where the gas is admitted; and
- extracting the residual gas from the enclosure from the other or second one of the inside and outer volumes, in such a manner that the gas flows inside the enclosure from the first volume to the second volume by diffusing through the pores of the substrate(s) and by passing through the or each leakage passage;
the method being **characterized by** the steps of:
- conferring a value to the total section of the leakage passage(s) such that the pressure difference between the first and second volumes at the beginning of the densification process is not less than 15% and not greater than 85% of the value of the pressure difference obtained in the absence of any leakage passage.

2. A method according to claim 1, **characterized in that** at least one stack of substrates is formed inside the enclosure with the central passages of the substrates being in alignment and with spaces being provided between adjacent substrates by means of spacers, said inside and outer volumes being constituted respectively by the inside and the outside of the stack(s), and at least one of the spacers is arranged to form the leakage passage(s) .

3. A method according to claim 2, **characterized in that** at least one annular spacer is used provided with at least one radial passage forming a leakage passage.

4. A method according to claim 2, **characterized in that** at least one spacer is used made up of a plurality of portions leaving leakage passages between one another.

5. A method according to any one of claims 2 to 4, **characterized in that** a plurality of spacers are arranged to form leakage passages, and the total section of the leakage passages is distributed in non-uniform manner along the height of the or each stack.

6. A method according to claim 5, **characterized in that** the leakage section between substrates varies, increasing from the end of the first volume where the gas is admitted to the opposite end.

7. A method according to any one of claims 1 to 6, **characterized in that** at least one leakage passage is arranged on the path channeling the gas between the gas inlet into the enclosure and the inlet into said first volume.

8. A method according to claim 7, **characterized in that** at least one leakage passage is arranged in a preheater zone for the gas.

9. A method according to any one of claims 1 to 8, **characterized in that** at least one leakage passage is arranged through a wall for closing said first volume at its end opposite from its end where the gas is admitted.

10. A method according to any one of claims 1 to 9, **characterized in that** the or each substrate is heated in the enclosure in substantially uniform manner.

11. A method according to any one of claims 1 to 9, **characterized in that** the or each substrate is heated in the enclosure with a temperature gradient being set up within the substrate.

12. A method according to claim 11, **characterized in that** the or each substrate is heated by direct inductive coupling with an induction coil.

13. A method according to any one of claims 2 to 12, **characterized in that** fibrous annular substrates are disposed inside the enclosure, said substrates constituting brake disk preforms.

14. A method according to any one of claims 1 to 12, **characterized in that** one or more fibrous substrates are disposed inside the enclosure, the substrates constituting one or more preforms for nozzle diverging portions.

15. A method according to any one of claims 1 to 12, **characterized in that** one or more fiber substrates are disposed inside the enclosure, the substrates being for making nozzle throats.
